# EUROPEAN PATENT APPLICATION

(11) **EP 2 924 144 A1**
(43) Date of publication of application: **30.09.2015**
(21) Application number: 14161904.9
(22) Date of filing: 27.03.2014
(51) Int. Cl.: C23F 4/00, F24J 2/07, F24J 2/48, F28F 13/18

(54) **Method for treating an outer surface of a heat transfer fluid tube**

(71) Applicant: NEM Energy B.V., 2595 BN 'S-Gravenhage (NL)
(72) Inventor: Rop, Peter Simon, 2731 BM Benthuizen (NL)
(74) Representative: Maier, Daniel Oliver

(57) **Abstract**

The present invention relates to a method for treating an outer surface (2) of a heat transfer fluid tube (1) especially for a receiver of a solar thermal power plant, comprising the steps: of providing the heat transfer fluid tube (1) and treating the outer surface (2) with a hydrogen plasma jet (3) so that a porosity in the range of a nano-scale is created in a thin layer of that outer surface (2).

## Description

The present invention relates to a method for treating an outer surface of a heat transfer fluid tube according to claim 1 and especially to a method for treating a heat transfer fluid tube for a receiver of a solar thermal power plant. In solar thermal power plants, like e.g. solar fields made out of heliostats arranged around a tower receiver, solar radiation is concentrated and reflected from the heliostats to a receiving area of the tower receiver. In this receiving area, heat transfer fluid tubes are arranged in such a way, that ideally almost all of the solar radiation reflected from the heliostats is used for heating the heat transfer fluid, flowing in the tubes. In a heat exchanger the heated fluid transfers the heat to a working fluid of a thermal power generation system. The heat transfer fluid can be for example molten salt or water/steam.

In reality the receiving area has the physical characteristic, that the radiation is not completely absorbed and thus the remainder of the incident radiation is reflected on the heat transfer fluid tubes. That leads to the fact, that the receiving area has an elevated temperature (because of the balance between absorption of radiation energy and cooling by the flowing medium) and thus the receiving area also emits radiation energy, as a function of its own temperature and emissivity characteristic.

The more efficient the receiver area is absorbing the projected solar radiation coming from the solar field, the smaller the solar field can be for a required output power of the total power plant. And since the solar field is about 45% of the total power plant costs, this can give a substantial cost saving.

Today the absorption of the receiver area is enhanced by applying a coating to the outside surface of the heat transfer fluid tubes. A typical commercially available coating is Pyromark, as known from "Solar Selective Coatings for Concentration", Advanced Materials & Processes, January 212. This coating increases the absorption coefficient of the heat transfer fluid tubes up to 95%, which is very close to a physical black body. Thus 95% of the incident radiation is absorbed and only 5% is reflected. But the problem of this coating is that the coating degrades by the high temperature of the receiver area during operating conditions. Experiences from the past show that after a few years, the absorption coefficient has decreased to less than 90%.

In physics, a perfect black body means that this body has the capability to completely absorb the incident radiation, so it has an absorption coefficient of 100%. This characteristic can also be approximated by applying a special geometry of the heat transfer fluid tubes in the receiving area. In the heat transfer fluid tubes the incident radiation is absorbed, and the reflected radiation is reflected randomly within the receiver area and thus back to other heat transfer fluid tubes of the receiver area. So the reflected radiation is not lost, but absorbed in a second instance, or even after more instances, depending on how often the radiation is reflected within the receiver area.

Another way how to achieve a physical black body is described in US 2012/0180783 A1. From US 2012/0180783 A1 it is known to improve the absorption of the heat transfer fluid tubes for linear concentrating solar thermal power plants with an extra absorber layer, wherein the absorber layer is generated by cold gas sputtering. Thus by applying suitable method parameters, an increased surface roughness can be achieved by means of pores in the surface region of the absorber layer.

It is an object of the present invention to provide an improved method for such a black body-like surface of a heat transfer fluid tube.

According to the present invention, this object is achieved with the method according to claim 1, comprising the steps of providing a heat transfer fluid tube and treating the outer surface of this heat transfer fluid tube with a hydrogen plasma jet, so that a porosity in the range of a nano-scale is created in a thin layer of that outer surface (2).

It is known from plasma technology, that a metallic surface becomes porous, when intensive hydrogen plasma is shot at such a surface. Applying this knowledge to the present method for treating an outer surface of heat transfer fluid tube, a porous crust of approximately one micrometer thickness and porosity in the nano-scale range can be achieved in a thin layer on the outer surface of the tube. Advantageously, when treating the surface of the heat transfer fluid tube with a hydrogen plasma jet, having an energy level with an Ion flux above 10e²⁴ m⁻²s⁻¹, a crust with a layer thickness of about around one micrometer and a nanometer structure smaller than 50nm can be created. For an incident solar radiation, the absorption characteristics of such a treated porous surface is very close to the characteristic of a perfect black body.

Typically, the heat transfer fluid tubes are made of chrome-steel alloy, or especially for higher heat transfer fluid temperatures stainless steel or nickel alloy. And in case of using nickel alloy as material for the heat transfer fluid tubes, the porous and thus high absorption thin layer can be achieved immediately on the base material of the tube.

In a preferred embodiment of the present invention the surface of the heat transfer fluid tube is first coated with an extra layer of a high absorbing material, other than the material of the heat transfer fluid tube. Such a high absorption material can be e.g. tungsten. Afterwards the surface of this extra and thin layer is treated with the hydrogen plasma jet. Because of the corrosion and high-temperature resilience of tungsten, the nano-structure will not deteriorate by atmospheric conditions and high temperature during operating conditions.

Applying the present invention to the heat transfer fluid tubes for a receiver of a solar thermal power plant leads to a constant absorbing layer at the outer surface of the tube with an efficiency very close to 100%. This means that the size of the solar field can be at least 5% smaller, resulting in a considerable cost saving.

The invention now will be explained in more detail with reference to the appended drawing. The drawings show only an example of a practical embodiment of the invention, without limiting the scope of the invention, in which:
- FIG 1: shows a cross-section through a heat transfer fluid tube where the inventive method is applied,
- FIG 2: shows an alternative embodiment of the present invention.

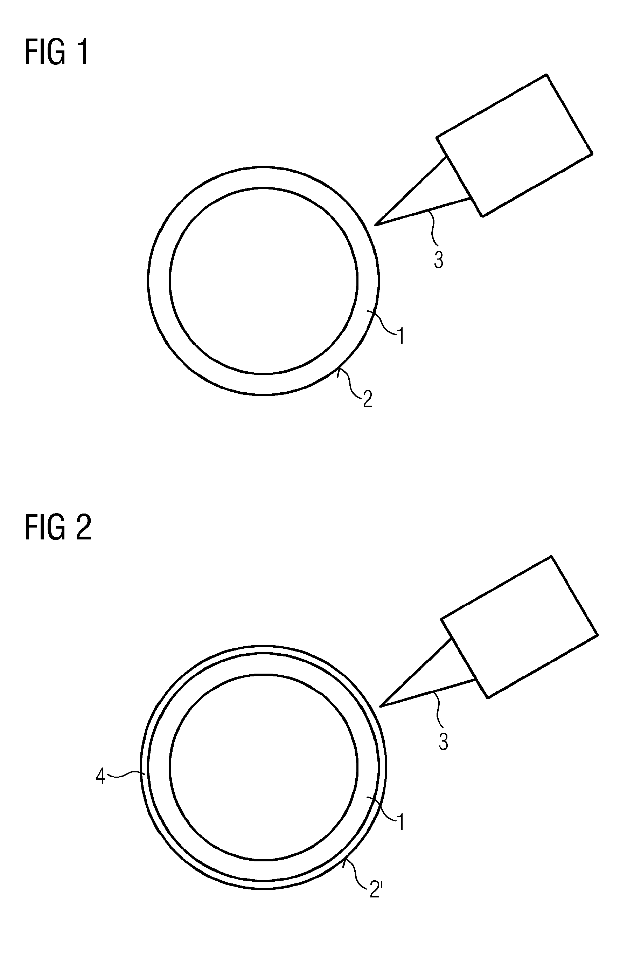

FIG 1 shows a cross-section of a heat transfer fluid tube 1. According to the present invention the outer surface 2 of this heat transfer fluid tube is treated with a hydrogen plasma jet 3. The schematic shown hydrogen plasma jet 3 comes from a hydrogen plasma source, which is not shown in greater detail. Also not shown are additional equipment for moving the tube and the hydrogen plasma jet relative to each other, which are needed for applying the hydrogen plasma to all three dimensions of the heat transfer fluid tubes surface. Applying a hydrogen plasma jet 3, having an energy level with an Ion flux above 10e²⁴ m⁻²s⁻¹, transforms a thin layer of the outer surface 2 to a porous crust with nano-scale porosity.

FIG 2 shows a cross-section of a preferred embodiment of the present invention. Here a high absorbing material, other than the material of the heat transfer fluid tube, is applied as an extra layer 4 on the surface of the heat transfer fluid tube 1. Subsequently the surface of this extra layer 4, which now forms the outer surface 2' of the heat transfer fluid tube 1, is treated with the hydrogen plasma jet 3. Therewith, high temperature resistant tube material like nickel alloy can be combined with high absorption material tungsten as an additional surface layer on the outer surface of the tube. Preferably, this additional tungsten layer of about one micrometer thickness is treated with the hydrogen plasma as long as the complete tungsten layer has a porosity of less than 50 nm.

Advantageously the aforesaid describes method is used for heat transfer fluid tubes of a receiver in a solar thermal power plant. But the method is also applicable to heat transfer fluid tubes in e.g. a furnace or other installations, where a very high-efficient absorption of incident radiation is needed.

## Claims

1. A method for treating an outer surface (2,2') of a heat transfer fluid tube (1), comprising the steps:
- providing the heat transfer fluid tube (1),
- treating the outer surface (2) with a hydrogen plasma jet (3) so that a porosity in the range of a nano-scale is created in a thin layer of that outer surface (2).

2. The method according to claim 1,
**characterized in that**
the material of the heat transfer fluid tube (1) is nickel alloy.

3. The method according to claim 1,
**characterized in that**
before treating the outer surface (2') with a hydrogen plasma jet (3), a high absorbing material, other than the material of the heat transfer fluid tube, is applied as an extra layer (4) on the surface of the heat transfer fluid tube (1).

4. The method according to claim 3,
**characterized in that**
the material of the heat transfer fluid tube (1) is stainless steel or nickel alloy and the material of the extra layer (4) is tungsten with a thickness of about one micrometer.

5. The method according to any of the claims 1 to 4,
**characterized in that**
the hydrogen plasma jet (3) having an energy level with an Ion flux above 10e²⁴ m⁻²s⁻¹.

6. Use of the method according to any of the claims 1 to 5 for heat transfer fluid tubes of a receiver in a solar thermal power plant.
